# EUROPÄISCHE PATENTSCHRIFT

(11) **EP 2 764 232 B1**
(45) Veröffentlichungstag und Bekanntmachung des Hinweises auf die Patenterteilung: **06.09.2017**
(21) Anmeldenummer: 12780111.6
(22) Anmeldetag: 05.10.2012
(51) Int. Cl.: F02M 51/06, H01L 41/053, F16K 31/00, F02M 63/00

(54) **PIEZOELEKTRISCHER AKTUATOR**
PIEZOELECTRIC ACTUATOR
ACTIONNEUR PIÉZOÉLECTRIQUE

(30) Priorität: 06.10.2011 DE 102011084107
(43) Veröffentlichungstag der Anmeldung: 13.08.2014
(73) Patentinhaber: Continental Automotive GmbH, 30165 Hannover (DE)
(72) Erfinder: KUSCHEL, Alexander, 93051 Regensburg (DE)
(86) Internationale Anmeldenummer: PCT/EP2012/069719
(87) Internationale Veröffentlichungsnummer: WO 2013/050528

(56) Entgegenhaltungen:
- DE-A1- 19 826 341
- DE-A1- 19 908 471
- DE-A1-102005 027 443
- GB-A- 2 094 940
- JP-A- 61 271 881

## Beschreibung

Die Erfindung betrifft einen piezoelektrischen Aktuator für einen Kraftstoffinjektor gemäß Anspruch 11.

### Stand der Technik

Es sind Kraftstoffinjektoren bekannt, die mittels eines piezoelektrischen Aktuators betätigt werden. Der piezoelektrische Aktuator weist ein Piezoelement auf, das in einer Umhausung aufgenommen ist. Ein zylindrisches Federelement umgibt das Piezoelement in Längsrichtung und komprimiert es, wodurch eine Vorspannung im Piezoelement erzeugt wird, um das Piezoelement, das üblicherweise viele piezokeramische Schichten umfasst, die jeweils abwechselnd mit Spannung beaufschlagt werden können, formstabil zu halten.

DE 199 40 055 C1 zeigt ein Dosierventil mit einem Piezoelement, bei dem eine axiale Vorspannung auf das Piezoelement mittels eines koaxialen Metallbalgs ausgeübt wird, welcher das Piezoelement umgibt.

DE 102 60 289 A1 zeigt einen Injektor mit einem ähnlichen Aufbau, wobei hier die Vorspannung mittels einer koaxialen Rohrfeder bereitgestellt ist.

DE 10 2004 006 266 A1 zeigt eine ebenfalls ähnliche Brennkraftmaschinen-Einspritzvorrichtung, bei der koaxiale Bälge die Vorspannung bewirken.

DE 199 06 467 A1 zeigt einen Injektor mit einem Piezoaktuator, bei dem eine axiale Vorspannung mittels einer Tellerfeder bewirkt wird, durch die in axialer Richtung der Aktorkörper verläuft.

DE 198 49 203 A1 zeigt ein Brennstoffeinspritzventil mit einer axial wirkenden Feder, die an einem axialen Ende eines Piezoaktuators anliegt.

GB 2 094 940 A offenbart einen piezoelektrischen Aktuator, bei dem ein Piezoelement durch eine Trennmembran vor einem Kontakt mit einem Kraftstoff geschützt ist.

Der Erfindung liegt die Aufgabe zugrunde, einen vereinfachten piezoelektrischen Aktuator für einen Kraftstoffinjektor anzugeben.

### Offenbarung der Erfindung

Die Erfindung löst die Aufgabe durch einen piezoelektrischen Aktuator mit den Merkmalen des Anspruchs 1. Unteransprüche geben Ausführungsformen an.

Erfindungsgemäß umfasst ein piezoelektrischer Aktuator für einen Kraftstoffinjektor ein Piezoelement, das in seiner Längsrichtung, die üblicherweise in Längsrichtung des Kraftstoffinjektors weist, ausgelenkt werden kann. Eine Trennwand schützt das Piezoelement vor Übertritt eines Mediums aus kraftstofführenden Abschnitten des Kraftstoffinjektors. Eine mechanische Vorspannung des Piezoelements in axialer Richtung wird durch die Trennwand im Zusammenwirken mit der Umhausung der Trennwand bewirkt. Dabei liegt die Trennwand an einem axialen Ende des Piezoelements an und erstreckt sich quer zur Betätigungsrichtung des Piezoelements. Dadurch können ein zusätzliches elastisches Element zur Komprimierung des Piezoelements sowie eventuell weitere Elemente zur Lagerung dieses elastische Elements entfallen, wodurch Herstellungskosten des piezoelektrischen Aktors gesenkt sein können. Der durch das Entfallen des elastischen Elements freiwerdende Bauraum kann genutzt werden, um den piezoelektrischen Aktuator kompakter auszuführen. Alternativ dazu kann der freiwerdende Bauraum durch ein vergrößertes Piezoelement ausgefüllt werden, um einen piezoelektrischen Aktuator mit erhöhter Leistungsdichte bei vergleichsweisen kleinerem Bauraum zu verwirklichen.

Das Piezoelement ist üblicherweise in seiner Umhausung zwischen der Trennwand und einem Abschlusselement angeordnet. Dadurch entsteht ein piezoelektrischer Aktuator als separat handhabbare Einheit, was zu Vorteilen bei der Montage des piezoelektrischen Aktuators für einen Kraftstoffinjektor führen kann. Darüber hinaus kann der piezoelektrische Aktuator auf diese Weise hermetisch verschlossen sein, sodass das Piezoelement von allen Seiten gegen ein Eindringen eines Mediums geschützt ist, welches das Piezoelement schädigen könnte, beispielsweise Kraftstoff.

Die Trennwand kann radial symmetrisch, also symmetrisch zu einer Längsachse des Piezoelements, geformt sein. Dadurch können Spannungen innerhalb der Trennwand symmetrisch wirken, wodurch die Trennwand die Vorspannung des Piezoelements auch nach einer großen Zahl Betätigungen, bei denen jeweils die Trennwand verformt wird, möglichst aufrecht erhalten kann und nicht beispielsweise unsymmetrische Spannung im Lauf der Zeit deformiert wird. Dabei kann die Trennwand eine Sicke aufweisen, die vorzugsweise radialsymmetrisch um die Symmetrieachse der Trennwand ausgebildet ist. Die Sicke kann derart ausgeformt sein, dass während eines Auslenkvorgangs des Piezoelements ein vorbestimmter Verlauf der Vorspannkraft auf das Piezoelement ausgeübt wird. In einer weiteren Ausführungsform können auch mehrere radialsymmetrische, d. h. konzentrische Sicken verwendet werden.

Die Trennwand kann in Richtung des Piezoelements gewölbt sein. Dadurch kann eine Vorspannkraft, die mittels der Trennwand auf das Piezoelement ausübbar ist, gesteigert sein. Ferner kann durch eine entsprechend ausgeformte Wölbung der Verlauf der Vorspannkraft über die axiale Betätigung des Piezoelements angepasst sein. Die Trennwand kann aus einem Stahlblech bestehen, wodurch eine gute Herstellbarkeit und Verarbeitbarkeit mit einer hohen Elastizität, einer hohen mechanischen Belastbarkeit und einer hohen Resistenz gegenüber aggressiven Medien, wie beispielsweise Kraftstoff, vereint ist.

Ein Verfahren zur Herstellung eines piezoelektrischen Aktuators für einen Kraftstoffinjektor umfasst Schritte des Bereitstellens eines Piezoelements zur axialen Auslenkung in dessen Längsrichtung, üblicherweise entlang der Längsrichtung des Kraftstoffinjektors, des Bereitstellens einer Trennwand zum Schutz des Piezoelements vor Übertritt eines Mediums aus dem kraftstoffführenden Bereich des Kraftstoffinjektors und des Anbringens der Trennwand am Piezoelement derart, dass eine Vorspannung des Piezoelements in Längsrichtung des Piezoelements durch die Trennwand bewirkt wird.

Die Erfindung wird nun mit Bezug auf die beigefügten Figuren genauer beschrieben, es zeigen:
Figur 1 einen Längsschnitt durch einen piezoelektrischen Aktuator;
Figur 2 Längsschnitte durch verschiedene beispielhafte Trennwände des piezoelektrischen Aktuators nach Figur 1; und
Figur 3 ein Ablaufdiagramm eines Verfahrens zur Herstellung des piezoelektrischen Aktuators aus Figur 1.

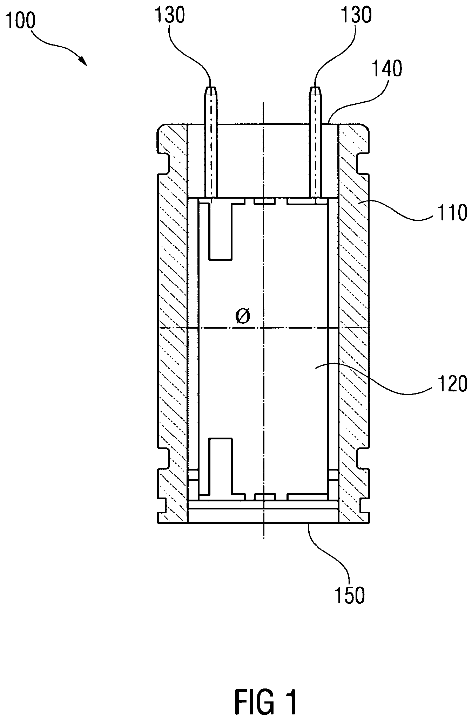

Figur 1 zeigt einen Längsschnitt durch einen piezoelektrischen Aktuator 100 für einen Kraftstoffinjektor. Der piezoelektrische Aktuator 100 umfasst eine im Wesentlichen zylindrische Umhausung 110, ein Piezoelement 120, elektrische Anschlüsse 130, eine Kopfplatte 140 und eine Trennwand 150. Die Umhausung 110 ist vorzugsweise aus Stahl gefertigt und trägt auf ihrer Außenseite mehrere umlaufende Nuten, um eine axiale Arretierung der Umhausung 110, beispielsweise in einem Kraftstoffinjektor, zu erleichtern.

Das Piezoelement 120 umfasst eine Anzahl piezokeramischer Elemente, die in axialer Richtung des piezoelektrischen Aktuators 100 stapelförmig angeordnet sind. In einer anderen Ausführungsform sind die piezokeramischen Elemente quer zur axialen Richtung des piezoelektrischen Aktuators 100 stapelförmig angeordnet. Das Piezoelement 120 liegt an seinem oberen Ende an der Kopfplatte 140 und an seinem unteren Ende an der Trennwand 150 an. Die Kopfplatte 140 besteht vorzugsweise aus Stahl und kann einstückig mit der Umhausung ausgeführt sein oder beispielsweise mittels Einpressen, Einschrauben, Verlöten, Verschweißen, Verstemmen, Bördeln oder einer anderen Weise mit der Umhausung 110 verbunden sein. Vorzugsweise ist die Verbindung der Kopfplatte 140 mit der Umhausung 110 derart ausgeführt, dass eine separate Dichtung nicht erforderlich ist, um im Bereich des oberen Endes des piezoelektrischen Aktuators 100 einen Übertritt eines aggressiven Mediums, wie beispielsweise Öl, Säure, Otto- oder Dieselkraftstoff, zum Piezoelement 120 zu verhindern.

Die elektrischen Anschlusselemente 130 führen in axialer Richtung durch Ausnehmungen in der Kopfplatte 140 und sind elektrisch mit dem Piezoelement 120 verbunden. Besteht die Kopfplatte 140 aus einem leitfähigen Material, so ist wenigstens einer der elektrischen Anschlüsse 130 elektrisch gegen die Kopfplatte 140 isoliert ausgeführt. Die elektrischen Anschlüsse 130 können beispielsweise mittels eines Kunststoffs oder einer Keramik elektrisch nicht leitend gegenüber der Kopfplatte 140 abgedichtet sein, so dass auch in diesem Bereich kein aggressives Medium zum Piezoelement 120 vordringen kann.

In einem unteren Bereich des piezoelektrischen Aktuators 100 ist die Trennwand 150 mit der Umhausung 110 verbunden. Die Trennwand (Membran) 150 besteht vorzugsweise aus Stahl, insbesondere aus einem federharten Stahl, der eine hohe Beständigkeit gegenüber Korrosion auch in aggressiven Medien aufweist. Die Trennwand 150 ist rundum dicht mit der Umhausung 110 verbunden, beispielsweise durch Schweißen, insbesondere Reibschweißen, oder eine der anderen oben mit Bezug auf die Kopfplatte 150 genannten Verbindungsarten.

In einer vorteilhaften Ausführungsform ist der piezoelektrische Aktuator 100 in einen Injektorkörper eingeführt und vorzugsweise mit diesem verschweißt. Dabei kann ein unausgefüllter Raum zwischen dem Aktuator 100 und dem Injektorkörper verbleiben. Die Trennwand 150 ist dann statt mit der Umhausung 110 mit dem Injektorkörper verbunden, vorzugsweise ebenfalls durch Schweißen und insbesondere durch Reibschweißen.

In einer weiteren Ausführungsform kann die Trennwand 150 einen oder mehrere Durchbrüche aufweisen, so dass die Trennwand hauptsächlich für eine vertikale Federung des Piezoelements 120 und weniger zur Abdichtung des Piezoelements 120 verwendet wird. Ein Schutz des Piezoelements 120 gegen aggressive Medien kann in diesem Fall durch eine separate Hülse oder eine keramische Passivierung erfolgen. Einer der Durchbrüche kann reisförmig oder in einer radialen Richtung schlitzförmig verlaufen. Die Längsachse des Aktuators 100 kann durch den Durchbruch hindurch verlaufen. Mehrere Durchbrüche können winkelsymmetrisch zur Längsachse angeordnet sein.

Das Piezoelement 120 ist in axialer Richtung zwischen der Kopfplatte 140 und der Trennwand 150 angeordnet. Wird das Piezoelement 120 angesteuert, indem eine elektrische Spannung an die elektrischen Anschlüsse 130 angelegt wird, so verändert das Piezoelement 120 seine axiale Ausdehnung. Die Kopfplatte 140 ist so ausreichend steif, um nicht nennenswert verformt zu werden. Die Trennwand 150 ist hingegen elastisch ausgebildet und verformt sich mit der Ausdehnungsänderung des Piezoelements 120. Durch die Verformung in axialer Richtung wird über die Trennwand 150 ein Ventil zur Steuerung eines Kraftstoffflusses betätigt.

Herkömmliche piezoelektrische Aktuatoren verwenden zur Erzeugung einer Vorspannung auf das Piezoelement 120 ein hohlzylindrisches Federelement, welches zwischen der Innenseite der Umhausung 110 und der Außenseite des Piezoelements 120 konzentrisch mit diesen beiden Elementen angeordnet ist und sich üblicherweise über die volle Länge des Piezoelements 120 erstreckt. Zur Herstellung eines Eingriffs des elastischen Elements beidseitig am Piezoelement sind häufig zusätzliche Befestigungs- bzw. Übertragungselemente erforderlich. Bei der in Figur 1 dargestellten Ausführungsform des piezoelektrischen Aktuators 100 können derartige Elemente entfallen. Dadurch kann der piezoelektrische Aktuator 100 gegenüber dem herkömmlichen Aktuator in radialer und/oder axialer Richtung kompakter ausgeführt sein. Alternativ dazu kann der freiwerdende Bauraum durch ein vergrößertes Piezoelement 120 ausgefüllt werden, wodurch bei gleichen Außenabmessungen eine erhöhte Leistungsfähigkeit und somit eine höhere Leistungsdichte des piezoelektrischen Aktuators 100 erzielt wird.

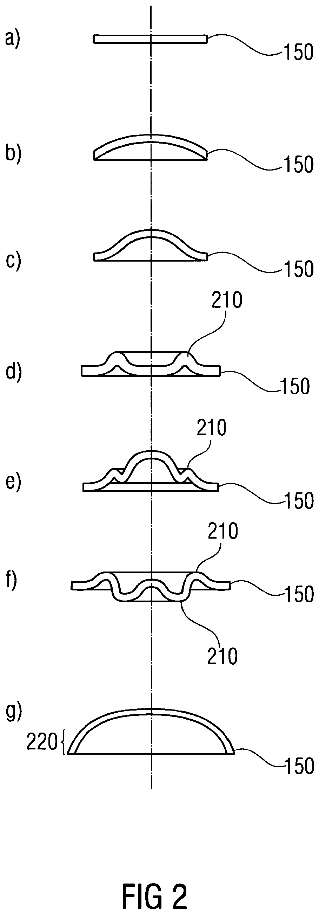

Figur 2 zeigt Längsschnitte durch verschiedene alternative Ausführungsformen der Trennwand 150 des piezoelektrischen Aktuators 100 aus Figur 1. Alle dargestellten Trennwände 150 sind radialsymmetrisch bezüglich der Längsachse des piezoelektrischen Aktuators 100 aus Figur 1. In weiteren, nicht dargestellten Ausführungsformen kann die Trennwand 150 auch einen nicht kreisförmigen Umriss haben. Der Umriss der Trennwand 150 kann insbesondere einem polygonalen Querschnitt der Umhausung 110 aus Figur 1 folgen. Die im Folgenden beschriebenen Sicken und Wölbungen können auch in diesem Fall wie dargestellt oder alternativ abschnittsweise parallel zu der inneren Begrenzung der Umhausung 110 verlaufen. Federeigenschaften der Trennwand 150, insbesondere eine Federkennlinie, werden durch die gezeigten Ausführungsformen variiert. Eine Dicke und ein Material der Trennwand 150 haben ebenfalls Einfluss auf die Federeigenschaften. Alle dargestellten Ausführungsformen können wie dargestellt oder umgedreht eingesetzt werden, so dass aus einer konkaven Wölbung oder Sicke eine konvexe Wölbung bzw. Sicke wird und umgekehrt.

Figur 2a zeigt die Trennwand 150 in einer flachen Ausführung entsprechend der Darstellung in Figur 1. Die Federeigenschaften der Trennwand 150 werden hauptsächlich durch das Material der Trennwand 150 und ihre Dicke bestimmt. Die Dicke der Trennwand 150 beträgt beispielsweise ca. 0,15 mm. Eine durch die Trennwand 150 auf das Piezoelement 120 in Figur 1 ausübbare Federkraft ist von einer ansteuerungsbedingten vertikalen Ausdehnung des Piezoelements 120 abhängig und kann in einem Bereich von ca. 50 N bis ca. 1500 N liegen, vorzugsweise in einem Bereich zwischen 100 N und 1000 N. Je nach Aufbau des Piezoelements 120 sind aber auch andere Federkräfte denkbar.

Figur 2b zeigt eine domartig gewölbte Ausführungsform der Trennwand 150. Die Wölbung in Figur 2b besteht in Richtung des Piezoelements 120, sodass eine größere Vorspannung auf das Piezoelement 120 wirken kann.

Figur 2c zeigt eine ähnlich wie in Figur 2b gewölbte Ausführungsform der Trennwand 150, wobei die Trennwand 150 glockenförmig geformt ist. Dadurch wird eine verbesserte Stabilität der Trennwand 150 in einem achsnahen Bereich mit einer guten Verformbarkeit in einem achsentfernten Bereich verbunden.

Figur 2d zeigt die Trennwand 150 in einer Ausführungsform ähnlich derer von Figur 2a, jedoch mit einer radialsymmetrischen, nach oben ausgeformten Sicke 210. Durch die Sicke 210 kann die Stabilität der Trennwand 150 auf einem vordefinierten Umfang beeinflusst werden, wodurch die Federkennlinie der Trennwand 150 gezielt verändert werden kann.

Figur 2e zeigt eine Ausführungsform der Trennwand 150, die aus einer Kombination der Ausführungsformen der Figuren 2b und 2d hervorgeht. Die gewölbte Trennwand 150 ist mit der Sicke 210 versehen. Durch diese Kombination lassen sich die Verformbarkeit und die Federkennlinie der Trennwand 150 weiter beeinflussen. Die Wölbung der Trennwand 150 kann dabei in einer weiteren Ausführungsform auch auf der Form von Figur 2c basieren.

Figur 2f zeigt eine Ausführungsform der Trennwand 150, die auf der Ausführungsform in Figur 2a basiert, wobei zwei Sicken 210 mit unterschiedlichen Radien und Richtungen entsprechend der Darstellung von Figur 2d in die Trennwand 150 eingebracht sind. Eine achsnahe Sicke 210 verläuft nach unten, eine achsentfernte Sicke 210 nach oben. Durch Einbringen mehrerer konzentrischer Sicken 210 lässt sich die Flexibilität der Trennwand 150 in axialer Richtung steigern. Die Federkennlinie der Trennwand 150 wird dadurch flacher.

Figur 2g zeigt eine weitere Ausführungsform der Trennwand 150 auf der Basis der in Figur 2b dargestellten Ausführungsform. Im Unterschied zu dieser geht in Figur 2g ein äußerer Randbereich der Trennwand 150 in einen konischen Kragen 220 mit einem Öffnungswinkel in einem Bereich von ca. 6 - 10° über. Ein Übergang des Randbereichs der Trennwand 150 in den Kragen 220 weist vorzugsweise einen Biegeradius auf, der größer als 1 mm, weiter vorzugsweise größer als 5 mm ist, so dass keine definierte umlaufende Kante erkennbar ist. Der Kragen 220 kann in axialer oder radialer Richtung mit der Umhausung 110 des Aktuators 100 aus Figur 1 verbunden werden. Der Kragen 220 ist auch mit jeder der in den Figuren 2a bis 2f dargestellten Ausführungsformen kombinierbar. Dabei kann jeweils der Übergang des Außenbereichs der Trennwand 150 zum Kragen 220 den oben angegebenen, relativ großen Biegeradius aufweisen.

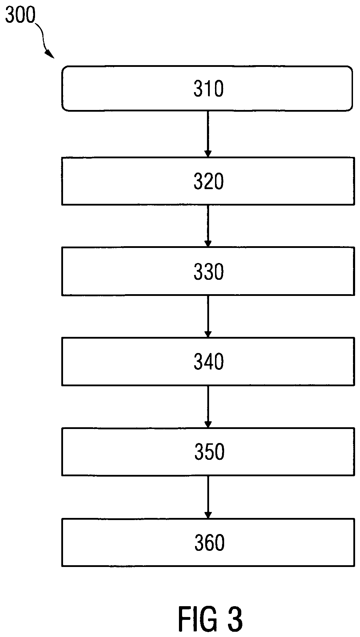

Figur 3 zeigt ein Verfahren 300 zur Herstellung des piezoelektrischen Aktuators 100 aus Figur 1. Das Verfahren 300 umfasst die Schritte 310 bis 360.

Im Schritt 310 befindet sich das Verfahren 300 im Startzustand. Im folgenden Schritt 320 werden das Piezoelement 120, die Umhausung 110, die Kopfplatte 140 mit den elektrischen Anschlüssen 130 und die Trennwand 150 bereitgestellt. Im anschließenden Schritt 330 wird das Piezoelement 120 in die Umhausung 110 eingeführt, wobei es funktionsbedingt in axialer Richtung beweglich bleibt, also nicht starr mit der Umhausung 110 verbunden wird. Dann wird im Schritt 340 die Kopfplatte 140 mit der Umhausung 110 verbunden, beispielsweise durch Verschweißen oder eine andere Verbindungsart. Dieser Schritt kann entfallen, falls die Kopfplatte 140 einstückig mit der Umhausung 110 ausgeformt ist. Danach wird im Schritt 350 die Trennwand 150 unter axialer Vorspannung mit der Umhausung 110 verbunden. Die gewünschte Vorspannung kann durch ein externes, in axialer Richtung wirkendes Klammerelement so lange aufgebracht werden, bis die Trennwand 150 mit der Umhausung 110 verbunden ist.

In anderen Ausführungsformen können die Schritte 330 bis 350 in ihrer Reihenfolge variiert sein, beispielsweise indem die Kopfplatte in Schritt 340 mit der Umhausung 110 verbunden wird, bevor in Schritt 330 das Piezoelement eingeführt wird.. Danach befindet sich das Verfahren 300 im Endzustand 360.

Durch den einfachen Aufbau des piezoelektrischen Aktuators 100 aus Figur 1 im Vergleich zu einem herkömmlichen Aktuator ist das Verfahren 300 zur Herstellung des piezoelektrischen Aktuators 100 gegenüber einem Verfahren zur Herstellung eines herkömmlichen Aktuators ebenfalls vereinfacht. Die Vereinfachung rührt hauptsächlich vom Entfallen von Schritten des Verbauens von separaten Federelementen für das Piezoelement 120 und Befestigungselementen für die Federelemente. Die Schritte 310 bis 360 des Verfahrens 300 unterscheiden sich nicht oder nur wenig von korrespondierenden Schritten eines Verfahrens zur Herstellung eines bekannten piezoelektrischen Aktuators. Das Verfahren 300 kann daher ohne große Änderungen an bestehenden Produktionsanlagen für piezoelektrische Aktuatoren durchgeführt werden.

## Patentansprüche

1. Piezoelektrischer Aktuator (100) für einen Kraftstoffinjektor, mit
einem Piezoelement (120) zur axialen Betätigung, wobei das Piezoelement (120) in einer Umhausung (110) zwischen einer Trennwand (150) zum Schutz des Piezoelements (120) vor Übertritt eines Mediums aus dem Kraftstoffinjektor und einem Abschlusselement (140) angeordnet ist;
- wobei das Piezoelement (120) in axialer Richtung vorgespannt ist; und
- die Vorspannung ausschließlich durch die Trennwand (150) im Zusammenwirken mit der Umhausung (110) bewirkt wird, so dass ein zusätzliches elastisches Element zur Komprimierung des Piezoelements sowie eventuell weitere Elemente zur Lagerung dieses elastische Elements entfallen, wobei
- die Trennwand (150) an einem axialen Ende des Piezoelements (120) anliegt und sich quer zur Betätigungsrichtung des Piezoelements (120) erstreckt.

2. Piezoelektrischer Aktuator (100) nach Anspruch 1, **dadurch gekennzeichnet, dass** das Abschlusselement (140) elektrische Anschlüsse (130) zur Ansteuerung des Piezoelements (120) umfasst.

3. Piezoelektrischer Aktuator (100) nach einem der vorangehenden Ansprüche, **dadurch gekennzeichnet, dass** die Trennwand (150) radialsymmetrisch geformt ist.

4. Piezoelektrischer Aktuator (100) nach einem der vorangehenden Ansprüche, **dadurch gekennzeichnet, dass** die Trennwand (150) eine Sicke (210) aufweist.

5. Piezoelektrischer Aktuator (100) nach einem der vorangehenden Ansprüche, **dadurch gekennzeichnet, dass** die Trennwand (150) in Richtung des Piezoelements (120) gewölbt ist.

6. Piezoelektrischer Aktuator (100) nach einem der vorangehenden Ansprüche, **dadurch gekennzeichnet, dass** die Trennwand (150) aus einem Stahlblech besteht.

## Claims

1. Piezoelectric actuator (100) for a fuel injector, comprising:
a piezoelement (120) for performing axial activation,
wherein the piezoelement (120) is arranged in a housing (110) between a dividing wall (150) for protecting the piezoelement (120) from an overflow of a medium from the fuel injector and a terminating element (140);
- wherein the piezoelement (120) is prestressed in the axial direction; and
- the prestress is brought about exclusively by the dividing wall (150) through interaction with the housing (110), with the result that an additional elastic element for compressing the piezoelement and possibly further elements for supporting this elastic element are dispensed with, wherein
- the dividing wall (150) bears against an axial end of the piezoelement (120) and extends transversely with respect to the direction of activation of the piezoelement (120).

2. Piezoelectric actuator (100) according to Claim 1, **characterized in that** the terminating element (140) comprises electrical terminals (130) for actuating the piezoelement (120).

3. Piezoelectric actuator (100) according to one of the preceding claims, **characterized in that** the dividing wall (150) is shaped in a radially symmetrical fashion.

4. Piezoelectric actuator (100) according to one of the preceding claims, **characterized in that** the dividing wall (150) has a bead (210).

5. Piezoelectric actuator (100) according to one of the preceding claims, **characterized in that** the dividing wall (150) is curved in the direction of the piezoelement (120).

6. Piezoelectric actuator (100) according to one of the preceding claims, **characterized in that** the dividing wall (150) is composed of sheet steel.

## Revendications

1. Actionneur piézoélectrique (100) pour un injecteur de carburant, avec
- un élément piézoélectrique (120) pour l'actionnement axial, dans lequel l'élément piézoélectrique (120) est disposé dans une gaine (110) entre une paroi de séparation (150) destinée à protéger l'élément piézoélectrique (120) contre la pénétration d'un fluide provenant de l'injecteur de carburant et un élément de fermeture (140);
- dans lequel l'élément piézoélectrique (120) est précontraint en direction axiale; et
- la précontrainte est provoquée exclusivement par la paroi de séparation (150) en coopération avec la gaine (110), de telle manière qu'un élément élastique supplémentaire pour comprimer l'élément piézoélectrique ainsi qu'éventuellement d'autres éléments pour le support de cet élément élastique soient supprimés,
- dans lequel la paroi de séparation (150) s'applique sur une extrémité axiale de l'élément piézoélectrique (120) et s'étend transversalement à la direction d'actionnement de l'élément piézoélectrique (120).

2. Actionneur piézoélectrique (100) selon la revendication 1, **caractérisé en ce que** l'élément de fermeture (140) comprend des raccords électriques (130) pour la commande de l'élément piézoélectrique (120).

3. Actionneur piézoélectrique (100) selon l'une quelconque des revendications précédentes, **caractérisé en ce que** la paroi de séparation (150) présente une forme à symétrie radiale.

4. Actionneur piézoélectrique (100) selon l'une quelconque des revendications précédentes, **caractérisé en ce que** la paroi de séparation (150) présente une moulure (210).

5. Actionneur piézoélectrique (100) selon l'une quelconque des revendications précédentes, **caractérisé en ce que** la paroi de séparation (150) est bombée en direction de l'élément piézoélectrique (120).

6. Actionneur piézoélectrique (100) selon l'une quelconque des revendications précédentes, **caractérisé en ce que** la paroi de séparation (150) est constituée par une tôle d'acier.
